# EUROPÄISCHE PATENTSCHRIFT

(11) **EP 1 321 959 B1**
(45) Veröffentlichungstag und Bekanntmachung des Hinweises auf die Patenterteilung: **29.04.2009**
(21) Anmeldenummer: 02023178.3
(22) Anmeldetag: 16.10.2002
(51) Int. Cl.: H01J 5/12, H01J 5/08, H05G 1/04, H01J 35/16

(54) **Gerät, das eine ionisierende Strahlung erzeugt**
Ionizing radiation generating device
Dispositif engendrant de la radiation ionisante

(30) Priorität: 10.12.2001 DE 10160402
(43) Veröffentlichungstag der Anmeldung: 25.06.2003
(73) Patentinhaber: Carl Zeiss NTS GmbH, 73446 Oberkochen (DE)
(72) Erfinder: Tobias, Daniel, 73447 Oberkochen (DE)
(74) Vertreter: Gnatzig, Klaus

(56) Entgegenhaltungen:
- EP-A- 0 319 244
- DE-A- 2 845 790
- US-A- 6 062 731
- PATENT ABSTRACTS OF JAPAN vol. 2002, no. 02, 2. April 2002 (2002-04-02) & JP 2001 273998 A (VARIAN MEDICAL SYSTEMS INC), 5. Oktober 2001 (2001-10-05)

## Beschreibung

Die Erfindung betrifft ein Gerät, das eine ionisierende Strahlung erzeugt. Derartige Geräte können beispielsweise Elektronenmikroskope oder Röntgenröhren oder sonstige Elektronenoder Partikelstrahlgeräte sein.

Aus der DE 28 45 790 ist es bei einem Röntgenrohr oder Ionenbeschleuniger bekannt, das Rohr, in dem die Elektroden zur Beschleunigung des Partikelstrahls aufgenommen sind, aus einem Blei oder ein anderes ionisierende Strahlung stark absorbierendes Schwermetall enthaltenden Epoxidharzgemisch zu fertigen. Alternativ wird vorgeschlagen, das konventionelle Röntgenrohr mit einem Schutzschild aus einem entsprechenden Epoxidharzgemisch zu umgeben. Dadurch soll ein sicherer Röntgenschutz gewährleistet werden.

Bei einem Schutzschild aus einem Blei enthaltenden Epoxidharzgemisch treten an Durchbrüchen beispielsweise für Manipulatoren, wie Blendenwechsler oder Probenmanipulatoren, die selben Probleme auf wie bei Schutzschildern aus Blei, d.h. es ist nahezu unmöglich das Schutzschild im Bereich eines Manipilators dicht gegen ausdringende Röntgenstrahlung zu bekommen. Gleiches gilt, wenn das die Komponenten, wie z.B. die Elektroden, tragende Rohr selbst aus einem Blei enthaltenden Epoxidharzgemisch besteht. Im letzteren Fall kommt hinzu, dass das Epoxidharzgemisch in der Regel nicht die Steifigkeit und Festigkeit aufweist, die insbesondere bei Elektonenmikroskopen für die Aufnahme der elektronenoptischen Komponenten erforderlich ist.

Es ist das Ziel der vorliegenden Erfindung eine Säule für ein ionisierende Strahlung erzeugendes Gerät anzugeben, mit der die Säule dicht gegen ausdringende Röntgenstrahlung ausgebildet werden kann und die erforderliche Steifigkeit und Festigkeit für die Aufnahme der teilchenoptischen Komponenten aufweisen kann.

Dieses Ziel wird erfindungsgemäß durch eine Ausbildung entsprechen den Merkmalen der Ansprüche 1 oder 2 gelöst. Vorteilhafte Ausführungsformen der Erfindung ergeben sich aus den abhängigen Ansprüchen.

Das erfindungsgemäße Gerät weist eine Säule in einer sandwichartigen Bauweise auf. In einer ersten Ausführungsform ist das Rohr, das die teilchenoptischen Komponenten trägt, außen von einer Schicht umgeben, die aus einem ein Schwermetall enthaltenden Epoxidharzgemisch besteht. Das Rohr und die Schicht aus dem Epodidharzgemisch sind dabei mit einander verklebt, so dass sie eine statische Einheit bilden.

Bei einer alternativen Ausführungsform weist die Säule ein Außenrohr und darin beabstandet ein Innenrohr auf. Der Zwischenraum zwischen dem Innenrohr und dem Außenrohr ist mit einem ein Schwermetall enthaltenden Epoxidharzgemisch ausgefüllt. Auch bei dieser Ausführungsform ist das Epoxidharz mit dem Innenrohr und/oder dem Außenrohr verklebt.

Als geeignetes, hinreichend Röntgenstrahlung absorbierendes Schwermetall kommen insbesondere Metalle mit einer Ordnungszahl größer gleich 75 wie Wolfram und/oder Blei oder chemische Verbindungen derselben, wie deren Oxide in Betracht.

Die gewünschte Verklebung des Epoxidharzgemisches mit dem Rohr oder Innen- und/oder Außenrohr sollt stellt sich in der Regel von selbst ein, wenn der Zwischenraum zwischen dem Innenrohr und dem Außenrohr mit dem Epoxidharzgemisch vergossen wird, oder der Zwischenraum zwischen dem Rohr und einer das Rohr umgebenden Gussform mit dem Epoxidharzgemisch ausgegossen wird.

Das verfestigte Epoxidharzgemisch ist in den Kraftfluß zwischen dem Außenrohr und dem Innenrohr eingebunden, d.h. die von den am Innenrohr aufgenommenen Komponenten auf das Innenrohr ausgeübten Kräfte werden über den mit dem Epoxidharzgemisch ausgefüllten Zwischenraum auf das Außenrohr übertragen. Ebenso ist bei der Ausführungsform mit nur einem Rohr die äußere Schicht aus dem Epoxidharzgemisch in den Kraftfluß eingebunden, denn die von angebrachten Komponenten, wie Manipulatoren oder Blendenwechsler, ausgeübten Kräfte werden über die Schicht aus dem Epoxidharzgemisch auf das Rohr übertragen.

Um die erforderliche Steifigkeit und Festigkeit zu gewährleisten besteht zweckmäßig mindestens eines der Rohre aus Stahl oder einer Stahllegierung. Besonders vorteilhaft ist es jedoch, wenn sowohl das Innenrohr als auch das Außenrohr metallisch sind, z.B. aus Stahl sind, da die sandwichartige Bauweise dann zusätzlich eine effiziente Abschirmung elektrischer und magnetischer Felder bewirkt.

Die Säule des Gerätes kann in axialer Richtung, also in Richtung der Achsen des Innen- und Außenrohres, aus mehreren hinter einander angeordneten Rohrstücken oder Innenrohrstücken und Außenrohrstücken bestehen. An den Verbindungsstellen, an denen die Rohrstücke an einander stoßen, sollten in einander greifende Aussparungen und Vorsprünge vorgesehen sein, so dass die mit dem Epoxidharzgemisch ausgefüllten Zwischenräume oder die Epoxidharzschichten an einander gefügter Rohrteile überlappen. Dadurch ist es möglich, das Gesamtgerät aus mehreren jeweils vorgefertigten Teilstücken zusammen zu setzten, ohne dass an den Verbindungsstellen Röntgenlöcher, also Stellen an denen Röntgenstrahlung aus dem Außenrohr in die Umgebung ausdringen kann, auftreten.

Die Säule kann in radialer Richtung eine oder mehrere Öffnungen mit einem darin aufgenommenen Manipulator oder Blendenhalter aufweisen. Der Manipulator sollte dabei eine Tragstruktur aufweisen, die ebenfalls mit einer Schicht eines ein Schwermetall enthalten Epoxidharzgemisches versehen ist. Die Dicke der Schicht sollte so gewählt sein, dass die Schicht aus dem Epoxidharzgemisch den Rand des Durchbruches durch das Rohr überdeckt.

Die Tragstruktur des Manipulators oder Blendenhalters sollte abgestuft oder konisch mit nach außen hin zunehmender Querabmessung ausgebildet sein. Dadurch lässt sich leichter erreichen, dass das Epoxidharzgemisch des Manipulators oder Blendenhalters und das Epoxidharzgemisch der Säule mindestens in einem Übergangsbereich überlappen, so dass auch an dem Durchbruch für den Manipulator oder Blendenhalter eine gegen Röntgenstrahlung dichte Ausbildung gewährleistet ist.

Weiterhin vorteilhaft sind am Manipulator oder Blendenhalter die in radialer Richtung der Säule angeordneten Komponenten, wie Bedienknöpfe, aus einem ein Schwermetall aufweisenden Epoxidharzgemisch ausgefüllt.

Nachfolgend werden weitere Einzelheiten der Erfindung anhand des in der Figur dargestellten Ausführungsbeispiels näher erläutert. Dabei zeigen die Figur einen Ausschnitt eines Gerätes mit einer sandwichartig ausgebildeten Säule im Bereich eines Manipulators im Schnitt.

In der Figur ist der Aufbau einer Säule eines Elektronenmikroskopes im Bereich der Objektivlinse dargestellt. Das Gesamtgerät hat einen an sich bekannten Aufbau mit einem Teilchenstrahlerzeuger und einem mehrstufigen Beleuchtungssystem mit zwei oder drei hinter einander entlang der optischen Achse angeordneten Magnetlinsen oberhalb des in der Figur dargestellten Ausschnittes und einem mehrstufigen Abbildungssystem mit drei oder mehr hinter einander angeordneten Magnetlinsen unterhalb des dargestellten Ausschnittes.

Die Säule weist ein Außenrohr (1) und ein im Außenrohr konzentrisch angeordnetes Innenrohr (2) auf. Das Außenrohr (1) und das Innenrohr (2) sind konzentrisch zur optischen Achse (OA) des Elektronenmikroskopes angeordnet.

Der Zwischenraum zwischen dem Innenrohr (2) und dem Außenrohr (1) ist mit einem Epoxidharzgemisch (3) ausgefüllt, das zu einem großen Anteil ein Schwermetall, z.B. Blei oder Bleioxid, enthält. Der Anteils an Schwermetall ist dabei so groß gewählt, dass die Absorption des Epoxidharzgemisches (3) für Röntgenstrahlung 50 - 75 % der Röntgenabsorption des reinen Schwermetalles entspricht.

Das Ausfüllen des Zwischenraumes erfolgt zweckmäßig durch Ausgießen, d.h. der Zwischenraum wird, nachdem das Innenrohr in das Außenrohr gestellt und in der relativen Positionierung gehalten ist, mit flüssigem Epoxidharzgemisch ausgefüllt. Zur Herstellung des Epoxidharzgemisches ist es dabei zweckmäßig, zunächst das Epoxidharz mit dem Starter zu aktivieren und das noch flüssige, aktivierte Epoxidharz mit den Schwermetall-Partikeln zu vermischen. Dadurch werden ungewünschte chemische Reaktionen zwischen dem Starter und den Schwermetallpartikeln vermieden.

Das Ausgießen des Zwischenraumes mit dem Epoxidharzgemisch führt nach dem Aushärten des Epoxidharzgemisches dazu, dass das Außenrohr (1) mit dem Innenrohr (2) durch das Epoxidharzgemisch verklebt ist.

Die gesamte Säule besteht aus mehreren in axialer Richtung, d.h. in Richtung der optischen Achse (OA), hinter einander angeordneten Säulenstücken. Dazu ist, wie in der Figur dargestellt, am unteren Ende des Säulenstückes mit dem Außenrohr (1) und dem Innenrohr (2) ein weiteres analog aufgebautes Säulenstück mit einem weiteren Außenrohrstück (4) und einem weiteren Innenrohrstück (5) angeordnet. Auch in diesem weiteren Säulenstück ist der Zwischenraum (6) zwischen dem weiteren Außenrohrstück (4) und dem weiteren Innenrohrstück (5) mit einem ein Schwermetall enthaltenen Epoxidharzgemisch ausgefüllt.

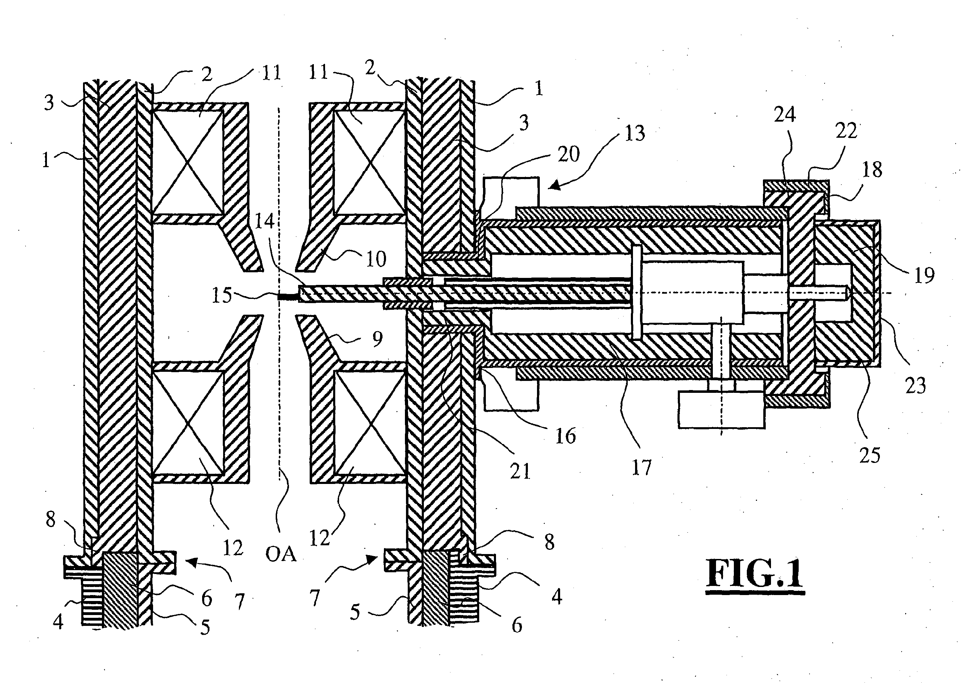

Im Übergangsbereich (7) zwischen beiden Säulenstücken weist die Verbindung zwischen beiden Säulenstücken eine Verzahnung auf. Dazu kann, wie in der Figur 1 dargestellt, das eine Innenrohr (2) gegenüber dem zugehörigen Außenrohr (1) verkürzt und das komplementäre Innenrohrstück (5) gegenüber dem zugehörigen Außenrohrstück (4) entsprechend verlängert sein. Durch geeignete Nachbearbeitung des Epoidharzgemisches des einen Säulenteils, z.B durch Drehen oder Fräsen, lässt sich erreichen, dass an einem Säulenteil ein die Verbindungsstelle überlappender Vorsprung (8) stehen bleibt. Dadurch ist gewährleistet, dass auch an einer solchen Verbindungsstelle (7) keine Röntgenstrahlung ungeschwächt austreten kann.

Die Säulenteile können in üblicher Weise mit einander verbunden sein, z.B. an den angedeuteten Flanschen mit einander verschraubt sein.

Um eine hinreichende Dicke des verbleibenden Vorsprunges zu gewährleisten, weist in dem dargestellten Ausrührungsbeispiel das Außenrohr (1) einen entsprechenden Ausschnitt auf.

Alternativ dazu ist es natürlich auch möglich, im Überlappungsbereich das Epoxidharzgemisch beider zu verbindenden Säulenstücke stufenförmig zu bearbeiten, dass die gewünschte Verzahnung im Übergangsbereich (7) gewährleistet ist.

Am Innenrohr (2) sind die erforderlichen elektronenoptischen Komponenten, im dargestellten Ausschnitt die Objektivlinse eines Transmissions-Elektronenmikroskopes mit den beiden Polschuhpaaren (9, 10) und den Magnetfeldspulen (11, 12) aufgenommen. Die Verbindung zwischen diesen Komponenten mit dem Innenrohr kann wie üblich durch Verschrauben über nicht dargestellt Anschläge und Flansche erfolgen.

An dem Außenrohr (1) ist auf der Höhe des Polschuhspaltes ein Manipulator (13) aufgenommen, der zur Bewegung und Positionierung des zu untersuchenden Objektes in der Brennebene der Objektivlinse dient. Der Manipulator weist eine hohle metallische Trägerstruktur (16), z.B. aus Aluminium oder Stahl auf, die im Bereich der Aufnahme am Außenrohr (1) gestuft mit nach außen zunehmender Abmessung, z.B. zunehmendem Durchmesser, ausgebildet ist. Der Außendurchmesser der Trägerstruktur weist entsprechend eine Stufe (20) auf. Der Innenraum der Trägerstruktur (16) ist wiederum mit einem ein Schwermetall enthaltenen Epoxidharzgemisch (17) ausgegossen. Durch die gestufte Ausbildung der Trägerstruktur (16), ist dessen verjüngtes Teil (21) in den Durchbruch der Säule einsetzbar, wobei gleichzeitig durch dessen gestufte Ausbildung das Loch im Außenrohr (1) durch den verdickten Teil des Manipulators überlappend abgedeckt wird, und zwar in Abhängigkeit von der Dicke der Trägerstruktur selbst so, dass das Epoxidharzgemisch (17) des Manipulators den Durchbruch durch die Säule überdeckt. Dadurch lässt sich gewährleisten, dass auch im Bereich des Manipulator-Durchbruches keine Röntgenstrahlung aus der Säule nach Außen an die Umgebung austreten kann.

Das Innenrohr (2) bildet das äußere Vakuumrohr des Gerätes, so dass das Epoxidharzgemisch nicht an das Vakuum angrenzt. Verunreinigungen des Vakuums durch aus dem Epoxidharz ausgasende Stoffe werden dadurch ausgeschlossen. Entsprechend erfolgt die Vakuumabdichtung des Manipulators am Innenrohr (2), so dass auch im Bereiches des Durchbruches für den Manipulator das Vakuum nicht an das Epoxidharzgemisch angrenzt.

Damit der Manipulator selbst Röntgendicht ist, sind auch die Triebknöpfe (18, 19) des Manipulators jeweils aus einer äußeren Trägerstruktur (22,23), die mit einem ein Schwermetall enthaltenen Epoxidharzgemisch ausgefüllt ist, ausgebildet. Die Dimensionierung der Triebknöpfe ist dabei so gewählt, dass der für die Manipulatormimik erforderliche Hohlraum im Inneren der Trägerstruktur von dem Triebknopf mindestens räumlich überdeckt ist, so dass aus dem Durchbruch austretende Röntgenstrahlung entweder im Epoxidharzgemisch der Manipulatorwände oder im Epoxidharzgemisch der Triebknöpfe absorbiert wird.

Die Herstellung eines entsprechenden Manipulators kann dadurch erfolgen, dass die Trägerstruktur zunächst mit dem Epoxidharzgemisch ausgegossen wird und nachfolgend die für Aufnahme der Manipulatormimik erforderliche Ausnehmung durch geeignete Bearbeitung wie Bohren, Drehen und Fräsen in das ausgehärtete Epoidharzgemisch eingearbeitet wird. Anschließend wir dann die Manipulatormimik in die Ausnehmung eingesetzt.

Der Manipulator selbst weist eine Stange (14) auf, die bis nahe an die optische Achse (OA) heranreicht und dessen Spitze die Aufnahme (15) für das zu untersuchende Objekt trägt. Durch Betätigung des Triebknopfes (19) lässt sich dann die Position des Objektes relativ zur optischen Achse variieren.

Analog zu dem Aufbau des beschriebenen Manipulators kann auch ein Blendenhalter aufgebaut sein, wobei dann lediglich die Manipulationsmimik entsprechend vereinfacht ist.

Alternativ zu der in der Figur dargestellten Ausführungsform ist es auch möglich, auf das Außenrohr (1) zu verzichten. In diesem Fall bildet dann die Epoxidharzschicht das Außenrohr. Eine solche Ausführungsform lässt sich dadurch erzeugen, dass das die teilchenoptischen Komponenten tragende Rohr (2) in eine Gussform gestellt wir und der sich dann ergebende Zwischenraum mit dem flüssigen Epoxidharz ausgegossen wird. Die Gussform kann dann anschließend entfernt werden. Die Gussform ist dabei zum Ausformen natürlich mit einer geeigneten Trennschicht zu versehen, die ein Verkleben des Epoxidharzgemisches mit der Gussform verhindert.

Ebenso ist es beim Manipulator möglich, die Epoxidharzschicht außen auf die Trägerstruktur aufzubringen; in diesem Fall erspart man sich ggf. das Herausarbeiten des für die Manipulatormimik erforderlichen Hohlraumes. Der Durchmesser der Trägerstruktur wird dann zweckmäßig so dimensioniert, dass der Hohlraum innerhalb der Trägerstruktur für die Aufrahme der Manipulatormimik ausreicht.

Die beiden letztgenannten Varianten haben jedoch den Nachteil, dass die das Schwermetall enthaltende Epoxidharzschicht nicht eingeschlossen ist und deshalb der Benutzer mit dem gebundenen Schwermetall in Berührung kommen kann.

Die Dicken der Schichten des Epoxidharzgemisches werden in jedem Fall - in Abhängigkeit von der Energie und Stärke der auftretenden Röntgenstrahlung und des Schwermetallanteils im Epoxisharzgemisch - so gewählt, dass die austretende Röntgenstrahlung innerhalb des Epoxidharzgemisches so stark absorbiert wird, dass Gesundheitsrisiken ausgeschlossen sind.

## Patentansprüche

1. Gerät, das eine ionisierende Strahlung erzeugt, wobei das Gerät ein Rohr (2) aufweist, das in seinem Inneren teilchenoptische Komponenten trägt, wobei
das Rohr außen von einer Schicht eines ein Schwermetall enthaltenden ausgehärteten Epoxidharzgemisches (3) umgeben ist, **gekennzeichnet dadurch, dass** das Epoxidharzgemisch (3) eine mit dem Rohr verklebte Einheit bildet.

2. Gerät, das eine ionisierende Strahlung erzeugt, mit einem Außenrohr (1) und einem innerhalb des Außenrohres (1) angeordneten Innenrohr (2), wobei der Zwischenraum zwischen dem Außenrohr (1) und dem Innenrohr (2) mit einem ein Schwermetall enthaltenden Epoxidharzgemisch (3) ausgefüllt ist,
**dadurch gekennzeichent, dass**
das Epoxidharzgemisch (3) mit dem Außenrohr (1) und/oder dem Innenrohr (2) verklebt ist.

3. Gerät nach Anspruch 1 oder 2, wobei das Epoxidharzgemisch (3) Blei enthält.

4. Gerät nach einem der Ansprüche 1 bis 3, wobei das Rohr, das Außenrohr (1) und/oder das Innenrohr (2) aus Stahl besteht.

5. Gerät nach einem der Ansprüche 2 - 4, wobei am Innenrohr (2) teilchenoptische Bauteile, insbesondere Linsen und/oder Elektroden aufgenommen sind.

6. Gerät nach einem der Ansprüche 1 - 5, wobei in axialer Richtung mehrere hinter einander angeordnete Rohrstücke oder Innenrohrstücke (2, 5) und Außenrohrstücke (1, 4), vorgesehen sind und wobei an den Verbindungsstellen (7) ineinander greifende Aussparungen und Vorsprünge (8) vorgesehen sind, so dass die mit dem Epoxidharzgemisch (3) ausgefüllten Zwischenräume oder die Epoxidharzschichten überlappen.

7. Gerät nach einem der Ansprüche 1 bis 6, wobei in radialer Richtung des Rohres oder Innenrohres (2) und Außenrohres (1) eine Öffnung mit einem darin aufgenommenen Manipulator (13) oder Blendenhalter vorgesehen ist und wobei der Manipulator (13) eine Tragstruktur (16) aufweist, die eine Schicht aus einem ein Schwermetall enthalten Epoxidharzgemisch (17) aufweist.

8. Gerät nach Anspruch 7, wobei die Tragstruktur (16) innen die Schicht aus einem ein Schwermetall enthalten Epoxidharzgemischs (17) aufweist.

9. Gerät nach Anspruch 7, wobei die Tragstruktur (16) außen von der Schicht aus einem ein Schwermetall enthalten Epoxidharzgemisch (17) umgeben ist.

10. Gerät nach einem der Ansprüche 7 bis 9, wobei die Schicht aus dem Epoxidharzgemisch (17) eine Dicke aufweist, so dass der Rand der Öffnung überdeckt ist.

11. Gerät nach Anspruch 10, wobei der Manipulator (13) oder Blendenhalter in radialer Richtung ein Abschlusselement aufweist, das eine Schicht aus einem Epoxidharzgemisch (17) aufweist.

12. Gerät nach Anspruch 11, wobei das Abschlusselement ein Bedienelement ist.

## Claims

1. Device which generates an ionizing radiation, the device having a tube (2) which supports particle-optical components in its interior, the tube being surrounded on the outside by a layer of an epoxy-resin mixture (3) containing a heavy metal, **characterized in that** the epoxy resin mixture (3) forms a unit adhering to the tube.

2. Device which generates an ionizing radiation, having an outer tube (1) and an inner tube (2) arranged inside the outer tube (1), the intermediate space between the outer tube (1) and the inner tube (2) being filled up with an epoxy-resin mixture (3) containing a heavy metal, **characterized in that** the epoxy-resin mixture (3) adheres to the outer tube (1) and/or to the inner tube (2).

3. Device according to Claim 1 or 2, in which the epoxy-resin mixture (3) contains lead.

4. Device according to one of Claims 1 to 3, in which the tube, the outer tube (1) and/or the inner tube (2) consists of steel.

5. Device according to one of Claims 2-4, in which particle-optical components, in particular lenses and/or electrodes are held on the inner tube (2).

6. Device according to one of Claims 1-5, in which a plurality of tube lengths or inner tube lengths (2, 5) and outer tube lengths (1, 4) arranged one behind another in an axial direction are provided, and in which interlocking cutouts and projections (8) are provided at the connecting sites (7) such that the interspaces filled up with the epoxy-resin mixture (3) or the epoxy-resin layers overlap.

7. Device according to one of Claims 1 to 6, in which an opening with a manipulator (3) or diaphragm holder held therein is provided in a radial direction of the tube or inner tube (2) and outer tube (1), and in which the manipulator (13) has a support structure (16) which has a layer made from an epoxy-resin mixture (17) containing a heavy metal.

8. Device according to Claim 7, in which on the inside the support structure (16) has the layer made from an epoxy-resin mixture (17) containing a heavy metal.

9. Device according to Claim 7, in which on the outside the support structure (16) is surrounded by the layer made from an epoxy resin mixture (17) containing a heavy metal.

10. Device according to one of Claims 7 to 9, in which the layer made from the epoxy-resin mixture (17) has a thickness such that the edge of the opening is covered.

11. Device according to Claim 10, in which in a radial direction the manipulator (13) or diaphragm holder has a terminal element which has a layer made from an epoxy-resin mixture (17).

12. Device according to Claim 11, in which the terminal element is an operating element.

## Revendications

1. Appareil émetteur de rayonnement ionisant, l'appareil présentant un tube (2) à l'intérieur duquel sont disposés des composants optiques en particules,
l'extérieur du tube étant entouré par une couche d'un mélange (3) de résine époxy durcie qui contient un métal lourd,
**caractérisé en ce que**
le mélange (3) de résine époxy forme avec le tube une entité collée.

2. Appareil émetteur de rayonnement ionisant, doté d'un tube extérieur (1) et d'un tube intérieur (2) disposé à l'intérieur du tube extérieur (1)
l'espace intermédiaire entre le tube extérieur (1) et le tube intérieur (2) étant rempli d'un mélange (3) de résine époxy qui contient un métal lourd,
**caractérisé en ce que**
le mélange (3) de résine époxy est collé sur le tube extérieur (1) et/ou sur le tube intérieur (2).

3. Appareil selon les revendications 1 ou 2, dans lequel le mélange (3) de résine époxy contient du plomb.

4. Appareil selon l'une des revendications 1 à 3, dans lequel le tube, le tube extérieur (1) et/ou le tube intérieur (2) sont réalisés en acier.

5. Appareil selon l'une des revendications 2 à 4, dans lequel des composants optiques en particules et en particulier des lentilles et/ou des électrodes sont placés sur le tube intérieur (2).

6. Appareil selon l'une des revendications 1 à 5, qui présente plusieurs pièces tubulaires ou pièces (2, 5) de tube intérieur et pièces (1, 4) de tube extérieur disposées les unes derrière les autres dans la direction axiale, des découpes et des saillies (8) qui s'engagent les unes dans les autres étant prévues sur les emplacements de liaison (7) de telle sorte que les espaces intermédiaires remplis du mélange (3) de résine époxy ou les couches de résine époxy soient superposés.

7. Appareil selon l'une des revendications 1 à 6, dans lequel une ouverture dans laquelle est logé un manipulateur (13) ou un porte-obturateur est prévue dans la direction radiale du tube ou du tube intérieur (2) et du tube extérieur (1), le manipulateur (13) présentant une structure porteuse (16) qui présente une couche d'un mélange (17) de résine époxy qui contient un métal lourd.

8. Appareil selon la revendication 7, dans lequel la structure porteuse (16) présente la couche de mélange (17) de résine époxy qui contient un métal lourd sur son côté intérieur.

9. Appareil selon la revendication 7, dans lequel l'extérieur de la structure porteuse (16) est entouré par la couche de mélange (17) de résine époxy qui contient un métal lourd.

10. Appareil selon l'une des revendications 7 à 9, dans lequel la couche de mélange (17) de résine époxy a une épaisseur telle que le bord de l'ouverture est recouvert.

11. Appareil selon la revendication 10, dans lequel le manipulateur (13) ou le porte-obturateur présente dans la direction radiale un élément de fermeture qui présente une couche de mélange (17) de résine époxy.

12. Appareil selon la revendication 11, dans lequel l'élément de fermeture est un élément d'actionnement.
